# EUROPEAN PATENT APPLICATION

(11) **EP 2 536 256 A1**
(43) Date of publication of application: **19.12.2012**
(21) Application number: 11742136.2
(22) Date of filing: 31.01.2011
(51) Int. Cl.: H05B 33/10, H01L 51/50, H05B 33/12, H05B 33/22

(54) **METHOD FOR PRODUCING LIGHT-EMITTING DEVICE**

(30) Priority: 09.02.2010 JP 2010026303
(71) Applicant: Sumitomo Chemical Company, Limited, Tokyo 104-8260 (JP)
(72) Inventor: GODA, Tadashi, Tsukuba-shi Ibaraki 305-0821 (JP)
(74) Representative: Jackson, Martin Peter
(86) International application number: PCT/JP2011/051863
(87) International publication number: WO 2011/099391

(57) **Abstract**

A method for manufacturing a light-emitting device (1) capable of manufacturing an organic EL element (11) causing less unevenness in light emission is provided using a nozzle printing method. This method is a method for manufacturing a light-emitting device comprising a supporting substrate, a plurality of partitions (3) extending in a line direction on the supporting substrate, and a plurality of organic EL elements provided in a plurality of concave portions (5). The manufacturing method comprises steps of forming one electrode (12), supplying an ink comprising a material to be an organic layer in a liquid columnar pattern to the concave portions and moving the supply position of the ink in one direction or the other direction of the line direction of the partitions from one end to the other end of the line direction, solidifying the ink supplied to the concave portions to form the organic layer, and forming the other electrode. At the step of supplying the ink, in each of the concave portions, the number of times of moving the ink supply position in one direction of the line direction and the number of times of moving the ink supply position in the other direction of the line direction are made the same as each other.

## Description

### TECHNICAL FIELD

The present invention relates to a method for manufacturing a light-emitting device and a method for manufacturing a thin film.

### BACKGROUND ART

Display devices comprise various types such as liquid crystal display devices and plasma display devices. As one type of display devices, a display device using organic electroluminescent (organic EL) elements as the light source of pixels has been put into practical use. This type of display device comprises a plurality of organic EL elements aligned and provided on a substrate. On the substrate, a plurality of partitions for dividing the organic EL elements are arrayed in a stripe pattern and the organic EL elements are individually arrayed in a plurality of concave portions defined by the partitions and the substrate. That is, the organic EL elements are individually provided in concave portions along the extending direction of the concave portions (hereinafter, the "extending direction of the concave portions" is called a line direction and a direction perpendicular to the line direction may be called, for example, a column direction) at prescribed intervals.

Each organic EL element comprises a pair of electrodes and one or more organic layers provided between the pair of electrodes. The organic EL element comprises at least one light-emitting layer as one or more organic layers. A plurality of organic EL elements are provided in concave portions along the line direction at prescribed intervals. The organic EL elements adjacent to each other in the line direction may only be electrically insulated and are not necessarily physically separated from each other. Therefore, an organic layer may be formed ranging over a plurality of organic EL elements.

As one method for forming an organic layer provided over a plurality of organic EL elements in a gap (concave portion) between the partitions adjacent to each other, a so-called nozzle printing method has been studied. In the nozzle printing method, ink comprising a material to be the organic layer is continuously supplied to a space between the partitions from one end to the other end of the space and the supplied ink is solidified to form the organic layer. Specifically, while discharging a liquid columnar ink from a nozzle disposed over the substrate, by reciprocating the nozzle in the line direction and by moving the substrate by a distance of prescribed lines in the column direction during the turn of the reciprocation of the nozzle, the ink is supplied to concave portions and further, by solidifying the ink, the organic layer is formed in concave portions (for example, see Patent Document 1).

### RELATED ART DOCUMENTS

### Patent Document

Patent Document 1: JP 2002-75640 A

### DISCLOSURE OF INVENTION

### PROBLEM TO BE SOLVED BY THE INVENTION

Although when the organic EL elements of the lines are manufactured under the same condition and the organic EL elements of the lines are caused to emit light under the same driving condition, it is of course expected that the organic EL elements emit light with the same brightness, when an organic EL element formed using the nozzle printing method is caused to emit light, there is observed such a phenomenon that the brightness of the emitted light is different for each line. Specifically, although in the nozzle printing method, the organic layer of each line is formed by reciprocating the nozzle in the line direction, there is observed such a phenomenon that the brightness of the emitted light is different between a line in which the organic layer is formed during the out-bound of the nozzle reciprocation and a line in which the organic layer is formed during the in-bound of the nozzle reciprocation.

Accordingly, it is an object of the present invention to provide a method for manufacturing a light-emitting device capable of manufacturing an organic EL element causing less unevenness in light emission using the nozzle printing method.

### MEANS FOR SOLVING PROBLEM

The present invention provides [1] to [14] below.
[1] A method for manufacturing a light-emitting device that comprises a supporting substrate, a plurality of partitions arranged on the supporting substrate at prescribed intervals in a column direction and extending in a line direction different from the column direction, and a plurality of organic electroluminescent elements provided in a plurality of concave portions each of which is a gap between the partitions adjacent to each other, each of the organic electroluminescent elements comprising a pair of electrodes and one or more organic layers provided between the pair of electrodes,
   the method comprising the steps of:
   forming one electrode among the pair of electrodes;
   supplying an ink comprising a material to be the organic layer in a liquid columnar pattern to the concave portions and moving a supply position of the ink in one direction or the other direction of the line direction of the partitions from one end to the other end of the line direction;
   solidifying the ink supplied to the concave portions to form the organic layer; and
   forming the other electrode among the pair of electrodes, wherein
   at the step of supplying the ink, in each of the concave portions, the number of times of moving the ink supply position in one direction of the line direction and the number of times of moving the ink supply position in the other direction of the line direction are made same as each other.
[2] The method for manufacturing the light-emitting device according to above [1], wherein at the step of supplying the ink, in each of the concave portions, the ink supply position is moved in one direction of the line direction and then moved further in the other direction in the same concave portion to reciprocate the ink supply positions for each concave portion to supply the ink.
[3] The method for manufacturing the light-emitting device according to above [1], wherein the step of supplying the ink comprises:
   a first step for moving the ink supply position so that the moving directions of the ink supply position in the concave portions adjacent to each other becomes different from each other to supply the ink to all the concave portions; and
   a second step for moving the ink supply position so that in each concave portion to which the ink has been already supplied in the first step, the moving direction of the ink supply position becomes different from the moving direction in the first step to further supply the ink to all the concave portions.
[4] The method for manufacturing the light-emitting device according to above [1], wherein the step of supplying the ink comprises:
   a first step for moving the ink supply position so that the moving directions of the ink supply position in the concave portions adjacent to each other become different from each other to supply the ink to all the concave portions; and
   a second step for moving the ink supply position so as to follow the moving direction of the ink supply position in the reverse direction from the moving direction in the first step to the concave portion to which the ink has been already supplied in the first step to further supply the ink to all the concave portions.
[5] The method for manufacturing the light-emitting device according to above [1], wherein the step of supplying the ink is a step for supplying two or more types of inks to the concave portions without overlapping the types of inks in each concave portion, and the step of supplying the ink comprises:
   a first step for moving the ink supply position in one direction of the line direction and then moving further in the other direction in the same concave portion to reciprocate the ink supply positions for each concave portion;
   a second step for repeating a step comprising moving the ink supply position from the concave portion to which an ink has been already supplied so as to skip a given number of lines of concave portions, where the given number is obtained by subtracting one from the number of types of inks, moving the ink supply position in one direction of the line direction, and then moving further in the other direction of the line direction in the same concave portion to reciprocate the ink supply positions for each concave portion; and
   a third step for repeating a step comprising moving the ink supply position in one direction of the line direction in a concave portion different from the concave portion to which the ink has been already supplied with using an ink of a type different from the ink that has been already supplied, moving further in the other direction in the same concave portion to reciprocate the ink supply positions for each concave portion, moving the ink supply position from the concave portion to which the ink has been already supplied so as to skip the give number of lines of concave portions, where the given number is obtained by subtracting one from the number of types of inks, moving the ink supply position in one direction of the line direction, and then moving further in the other direction in the same concave portion to reciprocate the ink supply positions for each concave portion.
[6] The method for manufacturing the light-emitting device according to above [1], wherein the step of supplying the ink is a step for supplying two or more types of inks to the concave portions without the types of inks in each concave portion, and the step of supplying the ink comprises:
   a first step for repeating a step comprising moving the ink supply position in one direction of the line direction, moving the ink supply position from the concave portion to which an ink has been already supplied so as to skip a given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
   a second step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks; and
   a third step for repeating a step comprising moving the ink supply position in the other direction of the line direction to supply the ink of the same type as the ink that has been already supplied to the concave portion to which the ink has been already supplied so that the moving direction of the ink supply position becomes different from the moving direction of the ink supply position of the ink that has been already supplied, moving the ink supply position from the concave portion to which the ink has been already supplied so as to skip the given number of lines of concave portions, where the given number is obtained by subtracting one from the number of types of inks, moving the ink supply position in one direction of the line direction, and moving the ink supply position from the concave portion to which the ink has been already supplied so as to skip the given number of lines of concave portions, where the given number is obtained by subtracting one from the number of types of inks.
[7] The method for manufacturing the light-emitting device according to above [1], wherein the step of supplying the ink is a step for supplying two or more types of inks to the concave portions without overlapping the types of inks in each concave portion, and the step of supplying the ink comprises:
   a first step for repeating a step comprising moving the ink supply position in one direction of the line direction, moving the ink supply position from the concave portion to which an ink has been already supplied so as to skip a given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
   a second step for further supplying the ink of the same type as the ink that has been already supplied to the concave portion to which the ink has been already supplied, by reciprocating the ink supply positions so as to follow the moving direction of the ink supply position in the reverse direction from the moving direction in the first step; and
   a third step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks, and thereafter repeating a step for further supplying the ink of the same type as the ink that has been already supplied to the concave portion to which the ink has been already supplied, by reciprocating the ink supply positions so as to follow the moving direction of the ink supply position in the reverse direction from the moving direction of the ink supply position of the ink that has been already supplied.
[8] A method for manufacturing a thin film for forming a thin film in a body to be coated comprising a supporting substrate and a plurality of partitions provided on the supporting substrate at subscribed intervals in a column direction and extending in a line direction different from the column direction, the method comprising the steps of:
   supplying a liquid columnar ink to a plurality of concave portions each of which is a gap between the partitions and moving an ink supply position in one direction or the other direction of the line direction of the partitions from one end to the other end of the line direction; and
   solidifying the ink supplied to the concave portions to form a thin film, wherein
   at the step of supplying the ink, in each of the concave portions, the number of times of moving the ink supply position in one direction of the line direction and the number of times of moving the ink supply position in the other direction of the line direction are made same as each other.
[9] The method for manufacturing a thin film according to above [8], wherein at the step of supplying the ink, in each of the concave portions, the ink supply position is moved in one direction of the line direction and then moved further in the other direction in the same concave portion to reciprocate the ink supply positions for each concave portion to supply the ink.
[10] The method for manufacturing a thin film according to above [8], wherein the step of supplying the ink comprises:
   a first step for moving the ink supply position so that the moving directions of the ink supply position in the concave portions adjacent to each other become different from each other to supply the ink to all the concave portions; and
   a second step for moving the ink supply position so that the moving direction of the ink supply position becomes different from the moving direction in the first step in each concave portion to which the ink has been already supplied in the first step to further supply the
   ink to all the concave portions.
[11] The method for manufacturing a thin film according to above [8], wherein the step of supplying the ink comprises:
   a first step for moving the ink supply position so that the moving directions of the ink supply position in the concave portions adjacent to each other become different from each other to supply the ink to all the concave portions; and
   a second step for moving the ink supply position so as to follow the moving direction of the ink supply position in the reverse direction from the moving direction in the first step in the concave portion to which the ink has been already supplied in the first step to further supply the ink to all concave portions.
[12] The method for manufacturing a thin film according to above [8], wherein the step of supplying the ink is a step of supplying two or more types of inks to the concave portions without overlapping the types of inks in each concave portion, and the step of supplying the ink comprises:
   a first step for moving the ink supply position in one direction of the line direction and then moving further in the other direction in the same concave portion to reciprocate the ink supply positions for each of the concave portions;
   a second step for repeating a step comprising moving the ink supply position from the concave portion to which an ink has been already supplied so as to skip a given number of lines of concave portions, where the given number is obtained by subtracting one from number of types of inks, moving the ink supply position in one direction of the line direction, and then moving further in the other direction in the same concave portion to reciprocate the ink supply positions for each concave portion; and
   a third step for repeating a step comprising moving the ink supply position in one direction of the line direction to a concave portion different from the concave portion to which the ink has been already supplied with using an ink of a type different from the ink that has been already supplied, moving further in the other direction in the same concave portion to reciprocate the ink supply positions for each concave portion, and then moving the ink supply position from the concave portion to which the ink has been already supplied so as to skip the given number of lines of concave portions, where the given number is obtained by subtracting one from the number of types of inks, moving the ink supply position in one direction of the line direction, and then moving further in the other direction in the same concave portion to reciprocate the ink supply positions for each concave portion.
[13] The method for manufacturing a thin film according to above [8], wherein the step of supplying the ink is a step of supplying two or more types of inks to the concave portions without overlapping the types of inks in each concave portion, and the step of supplying the ink comprises:
   a first step for repeating a step comprising moving the ink supply position in one direction of the line direction, moving the ink supply position from the concave portion to which the ink has been already supplied so as to skip a given number of lines of concave portions, where the given number is obtained by subtracting one from number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
   a second step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks; and
   a third step for repeating a step comprising moving the ink supply position in the other direction of the line direction to supply the ink of the same type as the ink that has been already supplied to the concave portion to which the ink has been already supplied so that the moving direction of the ink supply position becomes different from the moving direction of the ink supply position of the ink that has been already supplied, moving the ink supply position from the concave portion to which the ink has been already supplied so as to skip the number of lines of concave portions, where the given number is obtained by subtracting one from the number of types of inks, moving the ink supply position in one direction of the line direction, and moving the ink supply position from the concave portion to which the ink has been already supplied so as to skip the given number of lines of concave portions, where the given number is obtained by subtracting one from the number of types of inks.
[14] The method for manufacturing a thin film according to above [8], wherein the step of supplying the ink is a step of supplying two or more types of inks to the concave portions without overlapping the types of inks in each concave portion, and the step of supplying the ink comprises:
   a first step for repeating a step comprising moving the ink supply position in one direction of the line direction, moving the ink supply position from the concave portion to which an ink has been already supplied so as to skip a given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
   a second step for further supplying the ink of the same type as the ink that has been already supplied to the concave portion to which the ink has been already supplied, by reciprocating the ink supply positions so as to follow the moving direction of the ink supply position in the reverse direction from the moving direction in the first step; and
   a third step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks, and thereafter repeating a step for further supplying the ink of the same type as the ink that has been already supplied to the concave portion to which the ink has been already supplied, by reciprocating the ink supply positions so as to follow the moving direction of the ink supply position in the reverse direction from the moving direction of the ink supply position of the ink that has been already supplied.

### EFFECT OF THE INVENTION

According to the present invention, an organic EL element causing less unevenness in light emission can be manufactured using the nozzle printing method.

### BRIEF DESCRIPTION OF DRAWINGS

FIG. 1 is a plan view schematically illustrating a light-emitting device according to an embodiment.
FIG. 2 is a cross-sectional view schematically illustrating a light-emitting device.
FIG. 3 is a view schematically illustrating a track of the nozzle on a supporting substrate.
FIG. 4 is a view schematically illustrating a track of the nozzle on the supporting substrate.
FIG. 5 is a view schematically illustrating a track of the nozzle on the supporting substrate.
FIG. 6 is a view schematically illustrating a track of the nozzle on the supporting substrate.
FIG. 7 is a view schematically illustrating a track of the nozzle on the supporting substrate.

### DESCRIPTION OF EMBODIMENTS

Hereinafter, referring to the drawings, one embodiment of the present invention is described. In the descriptions below, it is only described that in each drawing, the shape, the size, and the arrangement of each component are schematically illustrated to such a degree as capable of comprehending the present invention, and each drawing should not be construed as limiting the scope of the present invention. In each drawing, the same component is indicated by attaching the same symbol and duplicate explanation may be omitted.
A method for manufacturing the light-emitting device of the present invention is a method for manufacturing a light-emitting device comprising a supporting substrate, a plurality of partitions provided on the supporting substrate at prescribed intervals in a column direction and extending in a line direction different from the column direction, and a plurality of organic EL elements provided in concave portions each of which is a gap between the partitions adjacent to each other, in which the organic EL element comprises a pair of electrodes and one or more organic layers provided between the pair of electrodes. The method for manufacturing the light-emitting device of the present invention relates to a method for manufacturing a light-emitting device comprising the steps of: forming one electrode among the pair of electrodes; supplying an ink comprising a material to be the organic layer in a liquid columnar pattern to the concave portions and moving the supply position of the ink in one direction or the other direction of the line direction of the partitions from one end to the other end of the line direction; solidifying the ink supplied to the concave portions to form the organic layer; and forming the other electrode among the pair of electrodes. At the step of supplying the ink, in each of the concave portions, the number of times of moving the ink supply position in one direction of the line directions and the number of times of moving the ink supply position in the other direction of the line directions are made the same as each other.

The light-emitting device is utilized, for example, as a display device. The display device comprises mainly an active matrix driving-type device and a passive matrix driving-type device and the present invention can be applied to both types of display devices. In the present embodiment, as one example, a light-emitting device applied to an active matrix driving-type display device is described.

### <Composition of light-emitting device>

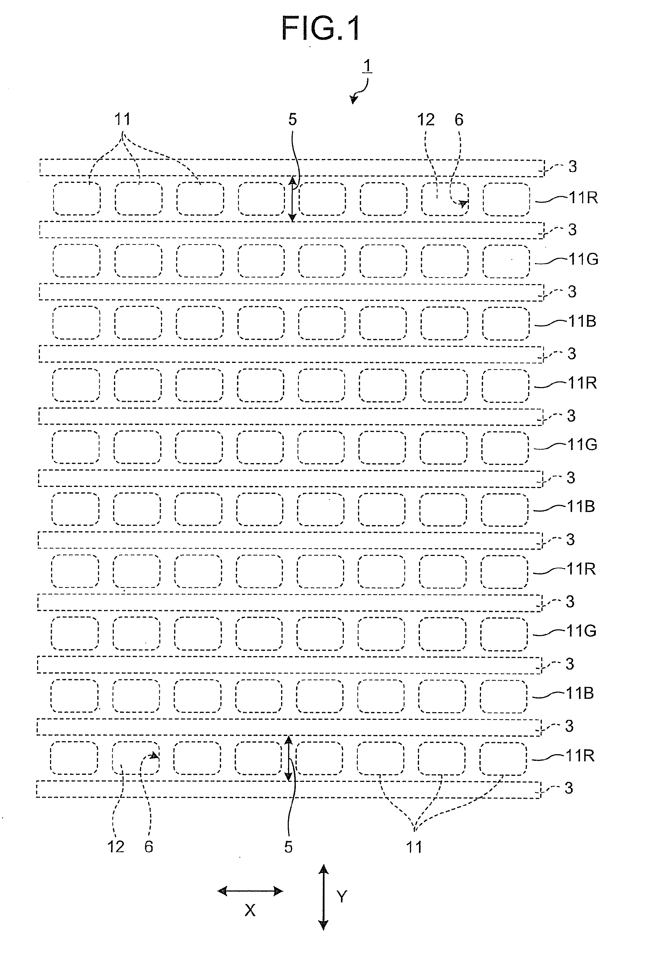

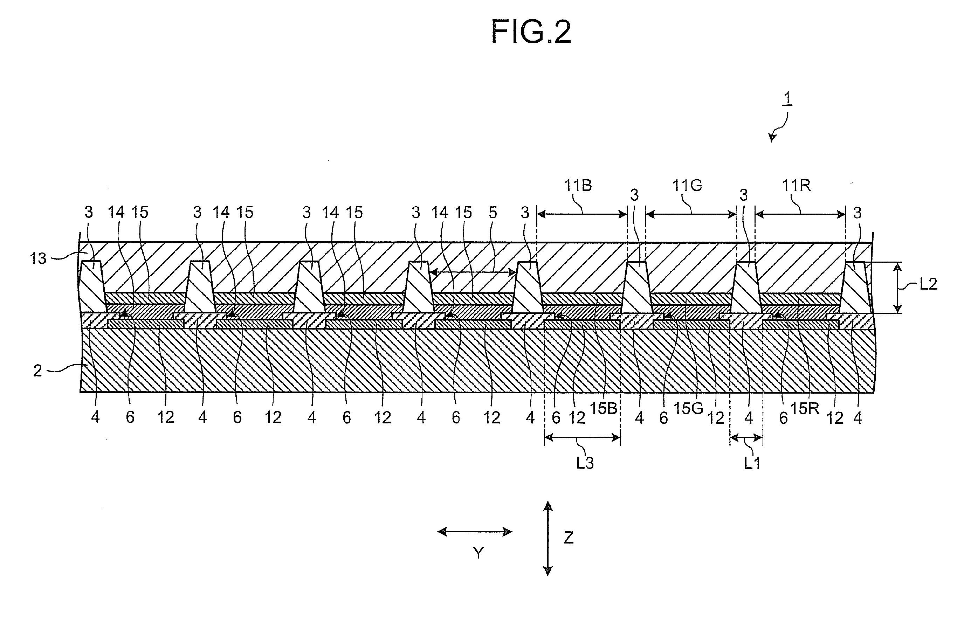

First, the composition of the light-emitting device is described. FIG. 1 is a plan view schematically illustrating the light-emitting device of the present embodiment, and FIG. 2 is a cross-sectional view schematically illustrating the light-emitting device.
As illustrated in FIG. 1 and FIG. 2, a light-emitting device 1 is constituted by mainly comprising: a supporting substrate 2; a plurality of organic EL elements 11 (11R, 11G, and 11B) formed on the supporting substrate 2; a partition 3 provided for dividing the organic EL elements 11; and an insulation film 4 for electrically insulating each organic EL element 11.

In the present embodiment, the organic EL elements 11 are individually aligned and arranged in a matrix pattern on the supporting substrate 2. That is, the organic EL elements 11 are individually arranged at a prescribed interval in the line direction X and at a prescribed interval in the column direction Y. In the present embodiment, the line direction X and the column direction Y cross orthogonally each other and each of the line direction X and the column direction Y crosses orthogonally the thickness direction Z of the supporting substrate 2.

In the present embodiment, a plurality of partitions 3 extending in the line direction X are provided on the supporting substrate 2. The partition 3 is provided in a so-called stripe pattern as viewed from a thickness direction (hereinafter, also called "in a plan view") of the supporting substrate 2. Each partition 3 is provided between the organic EL elements 11 adjacent to each other in the column direction Y. In other words, a plurality of organic EL elements 11 are provided between the partitions 3 adjacent to each other in the column direction Y and is provided in each space between the partitions 3 at prescribed intervals in the line direction X. Hereinafter, a depression (groove) defined by a pair of partitions 3 adjacent to each other in the column direction Y and the supporting substrate 2 may be called a concave portion 5. On the supporting substrate 2, a plurality of concave portions 5 are set. The concave portions 5 correspond to respective prescribed lines.

In the present embodiment, an insulation film 4 is provided between the supporting substrate 2 and the partition 3. The insulation film 4 is provided in a lattice pattern and is configured by integrally forming a plurality of belt-shaped parts extending in the line direction X and a plurality of belt-shaped parts extending in the column direction Y. In the lattice-patterned insulation film 4, a plurality of openings 6 are provided as lining up at the same intervals in the column direction and in the line direction. The opening 6 of the insulation film 4 is formed at a position at which the insulation film 4 is overlapped with the organic EL element in a plan view. The opening 6 of the insulation film 4 is formed in a shape such as a substantially rectangular shape, an oval shape, a substantially circular shape, and a substantially elliptical shape in a plan view. The partition 3 is formed on a part comprised in a part of the insulation film 4 and extending in the line direction X. The insulation film 4 is provided if necessary and is provided, for example, for securing electrical insulation between the organic EL elements adjacent to each other in the line direction X or in the column direction Y.

The organic EL element 11 comprises a pair of electrodes and one or more organic layers provided between the pair of electrodes and has as one or more organic layers, at least one light-emitting layer. In the present specification, a layer comprising an organic substance is called an organic layer. The organic EL element may comprise a layer comprising an inorganic substance and an organic substance, an inorganic layer, or the like. The organic EL element comprises, for example, a hole injection layer, a hole transport layer, an electron block layer, a light-emitting layer, a hole block layer, an electron transport layer, an electron injection layer, or the like as a layer provided between the pair of electrodes.

The pair of electrodes (12, 13) is constituted by an anode and a cathode. One electrode among the anode and the cathode is arranged at a position nearer to the supporting substrate 2 as one electrode 12 among the pair of electrodes, and the other electrode among the anode and the cathode is arranged at a position distant from the supporting substrate 2 farther than the one electrode 12 as the other electrode 13 among the pair of electrodes.

FIG. 2 illustrates, as one example, an organic EL element 11 in which an anode 12 corresponding to one electrode 12 among the pair of electrodes, a hole injection layer 14 corresponding to an organic layer, a light-emitting layer 15 corresponding to an organic layer, and a cathode 13 corresponding to the other electrode 13 among the pair of electrodes are layered in this order from the side of the supporting substrate 2.

The light-emitting device 1 of the present embodiment is an active matrix-type device, so that one electrode 12 is individually provided for an organic EL element 11. That is, the electrodes 12 as many as the organic EL elements 11 are provided on the supporting substrate 2. For example, the one electrode 12 is formed in a plate shape and in a substantially rectangular shape in a plan view. The electrodes 12 are provided in a matrix pattern on the supporting substrate 2 corresponding to the position at which each organic EL element 11 is provided. A plurality of electrodes 12 are arrayed at prescribed intervals in the line direction X and at prescribed intervals in the column direction Y. That is, the one electrode 12 is provided between the partitions 3 adjacent to each other in the column direction Y in a plan view and is arrayed in each space between the partitions 3 at prescribed intervals in the line direction X.

The above-described lattice-patterned insulation film 4 is formed mainly in a region excluding the one electrode 12 in a plan view and a part thereof is formed by covering the periphery of the one electrode 12. In other words, in the insulation film 4, the opening 6 is formed on the one electrode 12. Through the opening 6, the surface of one electrode 12 is exposed from the insulation film 4. The partitions 3 are provided on a plurality of belt-shaped parts constituting a part of the insulation film 4 and extending in the line direction X.

The organic layer (in the present embodiment, a hole injection layer 14 and a light-emitting layer 15) is provided in a region sandwiched by the partitions 3 extending in the line direction X. That is, the organic layer is formed in a belt in the concave portion 5 defined by the partitions 3 adjacent to each other in the column direction Y.

In the present embodiment, the hole injection layer 14 corresponding to one organic layer is provided in all organic EL elements 11 as a layer common to all the organic EL elements 11. On the supporting substrate 2, a plurality of types of organic EL elements 11 having different emitting light colors may be provided and for example, in the case of a color display device, three types of organic EL elements 11 emitting any one type of light among red light, green light, and blue light are provided on the supporting substrate 2. Thus, when a plurality of types of organic EL elements 11 emitting different color light components are formed, the light-emitting layers 15 emitting different color light are provided for the types of the organic EL element 11. In the present embodiment, the hole injection layer 14 influencing less on the emitted light color than the light-emitting layer 15 or the like is provided in all the types of organic EL elements 11 as a layer common to all the types of organic EL elements 11.
As another embodiment, even when it is a layer different from the light-emitting layer 15 (such as the hole injection layer and the electron injection layer), different types of layers may be formed for the types of the organic EL element 11.

In the present embodiment, three types of light-emitting layers 15R, 15G, 15B are provided. A color display device can be achieved, for example, by repeatedly arraying the lines (I), (II), and (III) below in this order in the column direction Y:
(I) a line in which a plurality of organic EL elements 11R emitting red light are arrayed at prescribed intervals;
(II) a line in which a plurality of organic EL elements 11G emitting green light are arrayed at prescribed intervals; and
(III) a line in which a plurality of organic EL elements 11B emitting blue light are arrayed at prescribed intervals.
In the present embodiment, by varying the type of the light-emitting layer 15, three types of organic EL elements 11 emitting any one type of light among red light, green light, and blue light are provided. Therefore, three types of lines such as (i) a line in which a light-emitting layer 15R emitting red light is provided, (ii) a line in which a light-emitting layer 15G emitting green light is provided, and (iii) a line in which a light-emitting layer 15B emitting blue light is provided, are repeatedly arrayed in this order in the column direction Y. That is, the belt-shaped light-emitting layers 15R, 15G, and 15B are sequentially layered on the hole injection layer individually with an interval of two lines from the other color light components in the column direction Y.

The other electrode 13 among the pair of electrodes is provided on the light-emitting layer 15. In the present embodiment, the other electrode 13 is formed continuously over a plurality of organic EL elements 11 and is provided as an electrode common to a plurality of organic EL elements 11. That is, the other electrode 13 is formed not only on the light-emitting layer 15, but also on the partition 3 and is formed all over so that an electrode on the light-emitting layer 15 and an electrode on the partition 3 line up.

### <Method for manufacturing a light-emitting device>

Next, the method for manufacturing a display device is described.

First, a supporting substrate 2 is prepared. As the supporting substrate 2 for an active matrix-type display device, a substrate in which a circuit for individually driving a plurality of organic EL elements 11 is formed beforehand, can be used. For example, a thin film transistor (TFT) substrate can be used as the supporting substrate 2.

### (Step of forming one electrode)

Next, on the prepared supporting substrate 2, a plurality of electrodes 12 are formed in a matrix pattern. One electrode 12 is formed, for example, by a method comprising the steps of: forming a conductive thin film all over on the supporting substrate 2; and patterning it in a matrix pattern by a photolithography method (in the description below, the "photolithography method" comprises a patterning step such as an etching process performed following a mask pattern forming process). The electrode 12 may be patterned, for example, by a method comprising the steps of: arranging a mask in which an opening is formed in a prescribed portion on the supporting substrate 2; and selectively depositing a conductive material in a prescribed portion on the supporting substrate 2 through the mask. The material for the electrode 12 is described below. In the present step, a substrate in which one electrode 12 is formed beforehand may be prepared as a supporting substrate 2.

Next, in the present embodiment, the insulation film 4 is formed in a lattice pattern on the supporting substrate 2. The insulation film 4 is constituted by an organic substance or an inorganic substance. The organic substance constituting the insulation film 4 may be resins such as an acrylic resin, a phenolic resin, or a polyimide resin. The inorganic substance constituting the insulation film 4 may be SiO₂ or SiN.

When an insulation film 4 comprising an organic substance is formed, first, for example, a positive or negative photosensitive resin is applied all over to the supporting substrate 2 and a prescribed portion is exposed and developed. Furthermore, by curing the resultant coating, there is formed an insulation film 4 in which the opening 6 is formed in a prescribed portion. As the photosensitive resin, a photoresist can be used. When an insulation film 4 comprising an inorganic substance is formed, a thin film comprising an inorganic substance is formed all over by a plasma CVD method, a sputtering method, or the like. Next, by forming the opening 6 in a prescribed portion, the insulation film 4 is formed. The opening 6 is formed, for example, by a photolithography method. By forming the opening 6, the surface of the electrode 12 is exposed.

Next, in the present embodiment, a plurality of stripe-shaped partitions 3 are formed on the insulation film 4. The partition 3 can be formed in a stripe pattern using, for example, a material included as the material for the insulation film 4 in the same manner as that for forming the insulation film 4.

The shape and the arrangement of the partition 3 and the insulation film 4 are appropriately set according to the specifications of the display device such as the number of pixels and the resolution and the easiness of the manufacturing. For example, the thickness L1 of each partition 3 in the column direction Y is around 5 µm to 50 µm; the height L2 of the partition 3 is around 0.5 µm to 5 µm; and the interval L3 between the partitions 3 adjacent to each other in the column direction Y, that is, the width L3 of the concave portion 5 in the column direction Y is around 20 µm to 200 µm. The widths of the opening formed in the insulation film 4 in the line direction X and the column direction Y are individually around 10 µm to 400 µm.

### (Step of forming organic layer)

Next, in the present embodiment, on the one electrode 12, the hole injection layer 14 is formed as one organic layer. The present step comprises the steps of: applying an ink comprising a material to be the organic layer (hole injection layer 14) in a liquid columnar pattern to the concave portions 5 each of which is a gap between the partitions 3 adjacent to each other and moving the supply position of the ink in one direction or the other direction of a line direction of the partitions 3 from one end to the other end of the line direction; and solidifying the ink supplied to the concave portion 5 to form the organic layer. In the present embodiment, by a so-called nozzle printing method, the hole injection layer 14 is formed.

In the nozzle printing method, the ink is supplied to each line (concave portion 5) by a one-stroke sketch. That is, while discharging the liquid columnar ink through a nozzle 16 disposed over the supporting substrate 2, the nozzle 16 is reciprocated in the line direction X and during the turn of the reciprocation of the nozzle 16, the supporting substrate 2 is moved in the column direction Y for a distance of one line to supply the ink to each line. In the present embodiment, although the nozzle 16 is reciprocated in the line direction and the supporting substrate 2 is moved in the column direction, on the contrary, the nozzle 16 may be moved in the column direction and the supporting substrate 2 may be reciprocated in the line direction. Furthermore, by moving only one of the nozzle 16 and the supporting substrate 2 in a prescribed direction, the ink may be supplied.

In the present embodiment, the number of times of moving the ink supply position in one direction of the line directions and the number of times of moving the ink supply position in the other direction of the line directions in concave portions 5 are made the same as each other. That is, in each of the concave portions 5, one reciprocation of the nozzle 16 is regarded as one set and the one set of reciprocation is performed once or more times.
Although there are a plurality of kinds of the track of the reciprocation of the nozzle 16 on each concave portion 5, as far as the reciprocation of the nozzle 16 is performed once or more times for each space between the partitions 3, the track of the nozzle 16 may be set in any way. For example, (a) the reciprocation of the nozzle 16 may be continuously performed for each space between the partitions 3, or (b) the ink may be supplied in a plurality of separate times and as a result thereof, the nozzle 16 may be caused to be reciprocated.

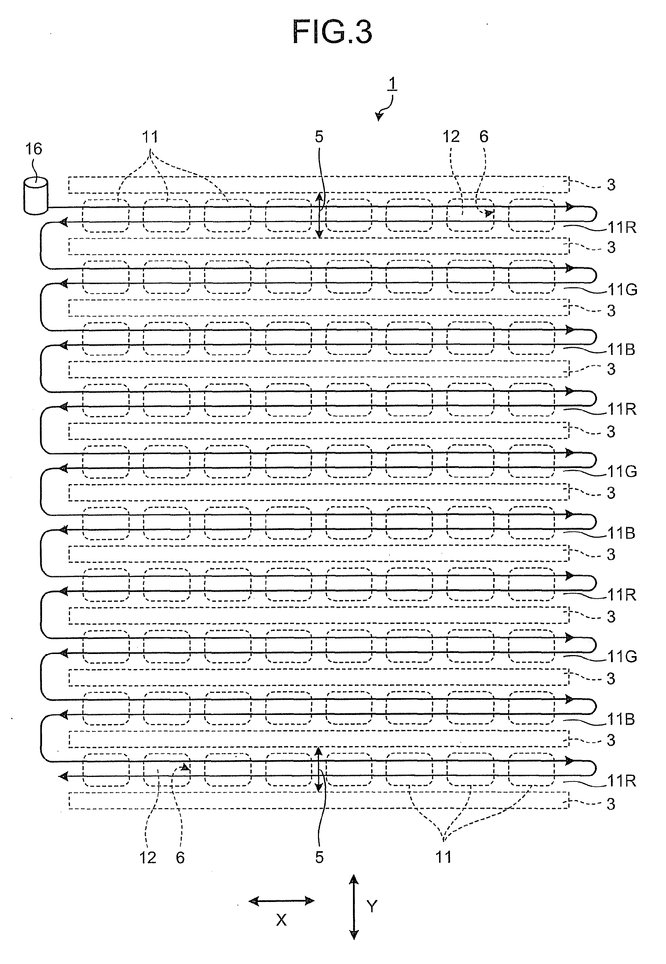

First, referring to FIG. 3, an ink supply method by (a) continuously performing the reciprocation of the nozzle 16 for each space between the partitions 3, is described. In FIG. 3, the track of the nozzle 16 is indicated with a solid line and using an arrow, the direction of moving of the nozzle 16 is indicated. In FIG. 3 and the following figures, the track of the nozzle 16 is indicated such that the track during the out-bound of the reciprocation is not overlapped with the track during the in-bound of the reciprocation. The nozzle 16 may be reciprocated so that the track during the out-bound is overlapped with the track during the in-bound.
This method is a method in which in each of the concave portions 5, the ink supply position is moved in one direction of the line directions and in the same concave portion 5, the ink supply position is moved in the other direction of the line directions to reciprocate the ink supply position for each concave portion 5 to supply the ink.
In this method, specifically, while discharging the liquid columnar ink through the nozzle 16 disposed over the supporting substrate 2, by alternately repeating the actions (1) and (2): (1) performing once or more times (in FIG. 3, one time) the reciprocation of the nozzle 16 in which on a prescribed line, the nozzle 16 is moved from one end to the other end in the line direction X and next, the nozzle 16 is moved from the other end to the one end in the line direction X; and (2) moving the supporting substrate 2 in the column direction Y for a distance of one line, the ink is accordingly supplied to each line.

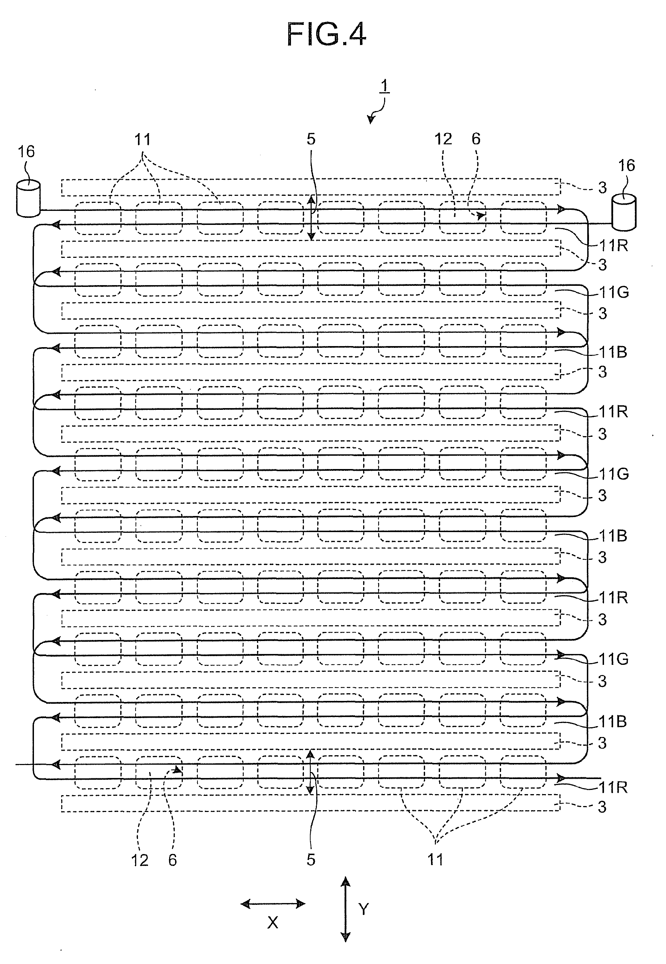

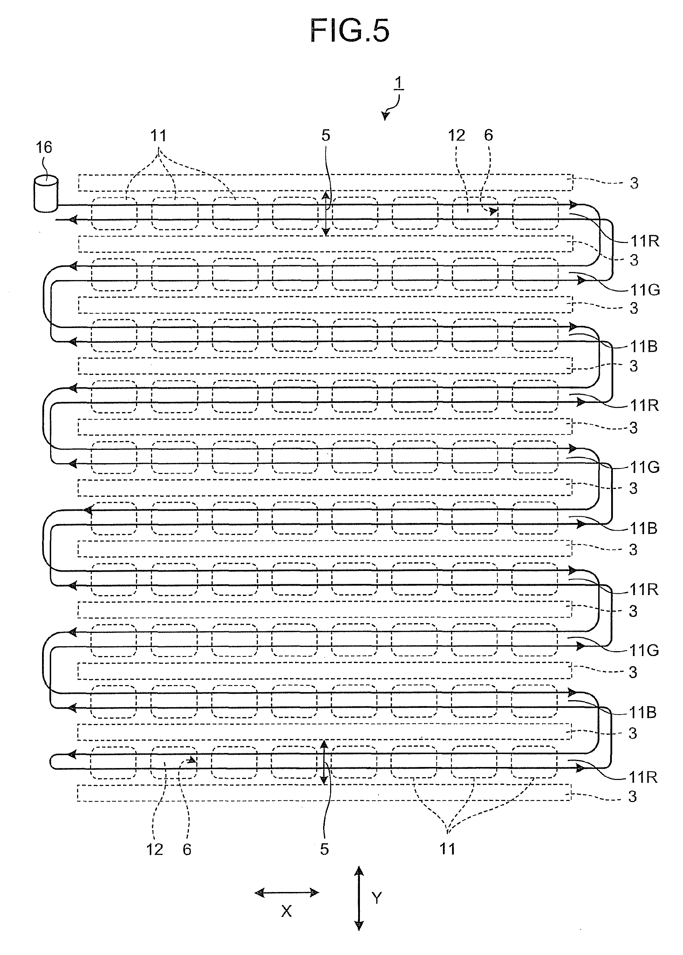

Next, referring to FIG. 4, a method in which (b) by supplying the ink in a plurality of separate times and as a result thereof, the nozzle is reciprocated on a prescribed line, is described.
In FIG. 4, the track of the nozzle 16 is indicated with a solid line and using an arrow, a direction in which the nozzle 16 is moved, is indicated. Hereinafter, when counting the number of lines from a line provided at one end of the column direction Y to a line provided at the other end of the column direction Y, a line disposed in the n-th line (the symbol "n" is a natural number) is defined as the n-th line.
In this method, the step of supplying the ink comprises: a first step for moving the ink supply position so that the moving directions of the ink supply position in the concave portions 5 adjacent to each other become different from each other to supply the ink to all the concave portions 5; and a second step for moving the ink supply position so that in each concave portion 5 to which the ink has been already supplied in the first step, the moving direction of the ink supply position becomes different from the moving direction in the first step to further supply the ink to all the concave portions 5.
In this method, for example, the ink supply in which the steps (1) to (4) below are repeated an even number of times. While discharging the liquid columnar ink through the nozzle 16 disposed over the supporting substrate 2, (1) on a prescribed line, the nozzle 16 is moved from one end to the other end of the line direction X, (2) the supporting substrate 2 is moved in one direction of the column direction Y for a distance of one line, (3) the nozzle 16 is moved from the other end to the one end in the line direction X, and (4) the supporting substrate is moved in one direction of the column direction Y for a distance of one line.
When the ink supply in which the steps (1) to (4) are repeated is performed an even number of times, for example, the ink supply is started from one end of the line direction X in the first line at an odd number of times of the ink supply and the ink supply is started from the other end of the line direction X in the first line at an even number of times of the ink supply.
As a result, the nozzle 16 is reciprocated on a prescribed line. Furthermore, as illustrated in FIG. 5, the nozzle 16 may be caused to be reciprocated on a prescribed line as a result of repeatedly performing the above steps (1) to (4), the ink supply is performed from the first line to a line at the other end of the column direction Y and then, by causing the nozzle 16 to follow the track of the nozzle 16 in the reverse direction, the ink supply may be performed from a line at the other end of the column direction Y to the first line. In other words, this method comprises: a first step for moving the ink supply position so that the moving directions of the ink supply position in the concave portions 5 adjacent to each other become different from each other to supply the ink to all the concave portions 5; and a second step for moving the ink supply position so as to follow the moving direction of the ink supply position in the reverse direction from the moving direction in the first step in the concave portion 5 to which the ink has been already supplied in the first step to further supply the ink to all the concave portions 5.

The organic layer (in the present embodiment, the hole injection layer 14) is formed by the solidification of the ink supplied between the partitions 3. The solidification of the ink can be performed, for example, by removing a solvent. The removal of the solvent can be performed by natural drying, heat-drying, or vacuum drying.
When the used ink comprises a material polymerized by applying energy such as light and heat, by applying energy such as light and heat to the ink after the ink is supplied, the organic layer may be solidified.

### (Step of forming light-emitting layer)

Next, the light-emitting layer 15 is formed. As described above, when a color display device is manufactured, for forming three types of organic EL elements 11, for example, a material for the light-emitting layer 15 is to be painted in different colors. For example, when three types of light-emitting layers 15 are formed for each line, red ink comprising a material emitting red light, green ink comprising a material emitting green light, and blue ink comprising a material emitting blue light are to be applied individually with an interval of two lines from the other color inks in the column direction Y. Then, by applying red ink, green ink, and blue ink sequentially to a prescribed line, each light-emitting layer can be deposited and formed. The method of sequentially applying red ink, green ink, and blue ink to a prescribed line may be prescribed applying methods such as a printing method, an inkjet method, or a nozzle printing method. For example, in the nozzle printing method, the ink can be supplied in the same manner as the above-described forming method of the hole injection layer 14.

There is described a method in which first, red ink is supplied to a prescribed line by the nozzle printing method and further, the ink is solidified to form a light-emitting layer 15R emitting red light.

The present step comprises the steps of: supplying an ink comprising a material to be an organic layer (in the present embodiment, a light-emitting layer 15R) in a liquid columnar pattern to the concave portions 5 each of which is a gap between the partitions 3 adjacent to each other and moving the supply position of the ink in one direction or the other direction of a line direction of the partitions from one end to the other end of the line direction; and solidifying the ink supplied to the concave portion 5 to form the organic layer (in the present embodiment, the hole injection layer 14).

The light-emitting layer 15R emitting red light is provided at an interval of two lines from the other color light components, so that the red ink is to be supplied at an interval of two lines. For example, while discharging a liquid columnar ink through the nozzle 16 disposed over the supporting substrate 2, the nozzle 16 is reciprocated in the line direction X and during the turn of the reciprocation of the nozzle 16, the supporting substrate 2 is moved in the column direction Y for a distance of three lines to supply the red ink at an interval of two lines.

In the present embodiment, in each of the concave portions 5, the number of times of moving the ink supply position in one direction of the line direction and the number of times of moving the ink supply position in the other direction of the line direction are made the same as each other. That is, in each of the concave portions 5, the reciprocation of the nozzle 16 is regarded as one set and the one set of reciprocation is performed once or more times. Although there are a plurality of kinds of the track of the reciprocation of the nozzle 16 on each concave portion 5, as far as the reciprocation of the nozzle 16 is performed once or more times for each space between the partitions 3, the track of the nozzle 16 may be set in any way. For example, (a) the reciprocation of the nozzle 16 may be continuously performed for each space between the partitions 3, or (b) the ink may be supplied in a plurality of separate times and as a result thereof, the nozzle 16 may be caused to be reciprocated.

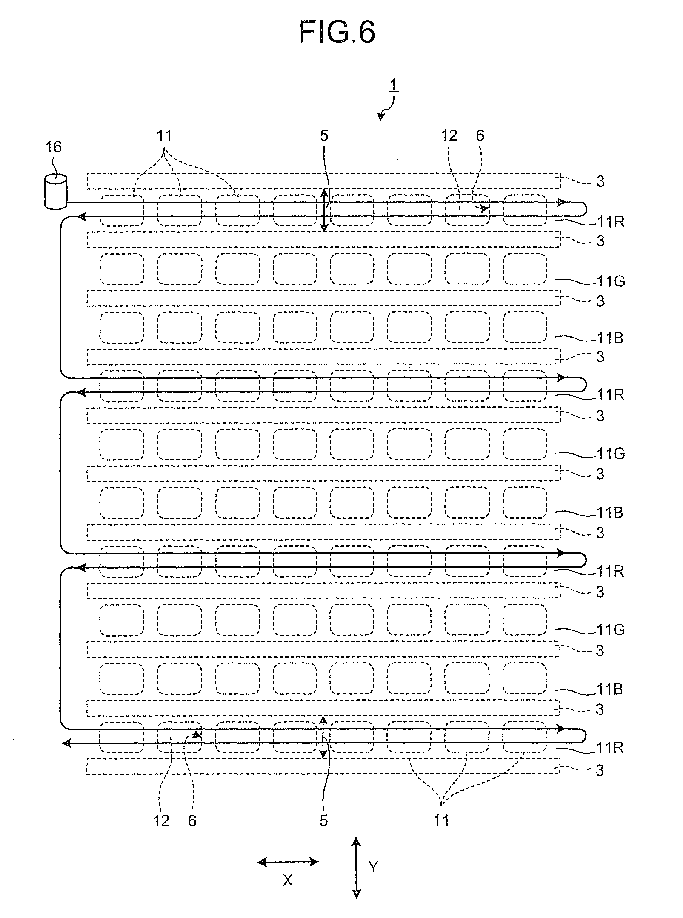

First, referring to FIG. 6, there is described an ink supply method in which (a) the reciprocation of the nozzle 16 is continuously performed for each space between the partitions.
In this method, the step of supplying the ink is a step of supplying two or more types of inks to concave portions 5 overlapping the type of inks in the concave portions 5 and comprises: a first step for moving the ink supply position in one direction of the line direction of the same concave portion 5 and moving the ink supply position in the other direction of the line direction to reciprocate the ink supply positions for a concave portion 5; a second step for repeating a step comprising moving the ink supply position from a concave portion 5 to which an ink has been already supplied so as to skip a given number of lines of concave portions 5, where the given number is obtained by subtracting one from the number of types of inks, moving the ink supply position of the same concave portion 5 in one direction of the line direction, and further moving the ink supply position in the other direction of the line direction to reciprocate the ink supply positions for each concave portion 5; and a third step for repeating a step comprising moving the ink supply position in one direction of the line direction to another concave portion 5 different from the concave portion 5 to which the ink has been already supplied and using an ink of a type different from the ink that has been already supplied, further moving the ink supply position of the same concave portion 5 in the other direction of the line direction to reciprocate the ink supply positions for each concave portion 5, moving the ink supply position from the concave portion 5 to which the ink has been already supplied so as to skip a given number of lines of concave portions 5, where the given number is obtained by subtracting one from the number of types of inks, moving the ink supply position in one direction of the line direction, and further moving the ink supply position of the same concave portion 5 in the other direction of the line direction to reciprocate the ink supply positions for each concave portion 5.
In this method, while discharging the liquid columnar ink through the nozzle 16 disposed over the supporting substrate 2, by alternately repeating the actions (1) and (2): (1) performing once or more times (in FIG. 6, one time) the reciprocation of the nozzle 16 in which on a predetermined line, the nozzle 16 is moved from one end to the other end in the line direction X and next, the nozzle 16 is moved from the other end to the one end in the line direction X; and (2) moving the supporting substrate 2 in the column direction Y for a distance of three lines, the red ink is accordingly supplied for every other two lines.

Next, a method in which (b) by supplying the ink in a plurality of separate times and as a result thereof, the nozzle 16 is reciprocated on a prescribed line, is described.
In this method, the step of supplying the ink is a step of supplying two or more types of inks to the concave portions 5 overlapping the type of inks in each concave portion 5 and comprises: a first step for repeating a step comprising moving the ink supply position in one direction of the line direction, moving the ink supply position from the concave portion 5 to which an ink has been already supplied so as to skip a given number of lines of concave portions 5, where the given number is obtained by subtracting one from the number of types of inks, moving the ink supply position in the other direction of the line direction, and moving the ink supply position from the concave portion 5 to which the ink has been already supplied so as to skip a given number of lines of concave portions 5, where the given number is obtained by subtracting one from the number of types of inks; a second step for repeating a step comprising moving the ink supply position in one direction of the line direction to the next concave portion 5 from the concave portion 5 to which the ink has been already supplied and using an ink of a type different from the ink which has been already supplied, moving the ink supply position from the concave portion 5 to which the ink has been already supplied so as to skip a given number of lines of concave portions 5, where the given number is obtained by subtracting one from the number of types of inks 5, moving the ink supply position in the other direction of the line direction, and moving the ink supply position from the concave portion 5 to which the ink has been already supplied so as to skip a given number of lines of concave portions 5, where the given number is obtained by subtracting one from the number of types of inks; and a third step for repeating a step comprising moving the ink supply position in the other direction of the line direction to supply an ink of the same type as the ink that has been already supplied to the concave portion 5 to which the ink has been already supplied so that the moving direction of the ink supply position becomes different from the moving direction of the ink supply position of the ink that has been already supplied, moving the ink supply position from the concave portion 5 to which the ink has been already supplied so as to skip a given number of lines of concave portions 5, where the given number is obtained by subtracting one from the number of types of inks, moving the ink supply position in one direction of the line direction, and moving the ink supply position from the concave portion 5 to which the ink has been already supplied so as to skip a given number of lines of concave portions 5, where the given number is obtained by subtracting one from the number of types of inks.
In this method, for example, an ink supply by repeating the steps (1) to (4) below is performed an even number of times. While discharging the liquid columnar ink through the nozzle 16 disposed over the supporting substrate 2, (1) on a prescribed line, the nozzle 16 is moved from one end to the other end in the line direction X, (2) the supporting substrate is moved in one direction of the column direction Y for a distance of three lines, (3) the nozzle 16 is moved from the one end to the other end in the line direction X, and (4) the supporting substrate is moved in one direction of the column direction Y for a distance of three lines. When the ink supply in which the steps (1) to (4) are repeatedly performed, is performed an even number of times, for example, the ink supply is started from the one end of the line direction X at an odd number of times of the ink supply and the ink supply is started from the other end of the line direction X at an even number of times of the ink supply. As a result, the nozzle 16 is reciprocated on a prescribed line.
Furthermore, the nozzle 16 may be caused to be reciprocated on a prescribed line as a result of by repeatedly performing the above steps (1) to (4), the ink supply is performed sequentially from one line in the column direction Y to another line in the column direction Y and following the track of the nozzle 16 in the reverse direction, the ink supply is performed in the reverse order from the other line in the column direction Y to the one line in the column direction Y.
In other words, in this method, the step of supplying the ink is a step of supplying two or more types of inks to the concave portions 5 overlapping the type of inks in each concave portion 5 and comprises: a first step for repeating a step comprising moving the ink supply position in one direction of the line direction, moving the ink supply position from a concave portion 5 to which an ink has been already supplied so as to skip a given number of lines of concave portions 5, where the given number is obtained by subtracting one from the number of types of inks, moving the ink supply position in the other direction of the line direction, and moving the ink supply position from the concave portion 5 to which the ink has been already supplied skipping the number of lines of concave portions 5, where the number is obtained by subtracting one from the number of types of inks; a second step for further supplying an ink of the same type as the ink that has been already supplied to the concave portion 5 to which the ink has been already supplied by reciprocating the ink supply positions so as to follow the moving direction of the ink supply position in the reverse direction from the moving direction in the first step; and a third step for repeating a step comprising moving the ink supply position in one direction of the line direction to the next concave portion 5 from the concave portion 5 to which the ink has been already supplied and using an ink of a type different from the ink that has been already supplied, moving the ink supply position from the concave portion 5 to which the ink has been already supplied so as to skip a given number of lines of concave portions 5, where the given number is obtained by subtracting one from the number of types of inks, moving the ink supply position in the other direction of the line direction, and moving the ink supply position from the concave portion 5 to which the ink has been already supplied so as to skip a given number of lines of concave portions 5, where the given number is obtained by subtracting one from the number of types of inks, and thereafter repeating a step for further supplying an ink of the same type as the ink that has been already supplied to a concave portion 5 to which the ink has been already supplied by reciprocating the ink supply positions so as to follow the moving direction of the ink supply position in the reverse direction from the moving direction of the ink supply position of the ink that has been already supplied.

The organic layer (light-emitting layer 15) is formed by solidifying the ink supplied between the partitions 3. The solidification of the ink can be performed, for example, by removing the solvent.
The removal of the solvent can be performed by natural drying, heat-drying, vacuum drying, or the like. When the used ink comprises a material polymerized by applying energy such as light and heat, the organic layer may be solidified by applying energy such as light and heat to the ink after the ink is supplied.

With respect to the green ink and the blue ink, like the red ink, by supplying the ink with an interval of two lines from the other types of inks between the partitions 3 to which the other inks are supplied, a light-emitting layer 15G emitting green light and a light-emitting layer 15B emitting blue light individually can be formed.

After the light-emitting layer 15 is formed, if necessary, a prescribed organic or inorganic layer and the like are formed by a prescribed method. These layers may be formed using a certain applying method such as a printing method, an inkjet method, and a nozzle printing method and further, a certain dry method.

### (Step of forming the other electrode)

Next, the other electrode is formed. As described above, in the present embodiment, the other electrode 13 is formed all over on the supporting substrate 2. A plurality of organic EL elements 11 can be thus formed on the substrate.

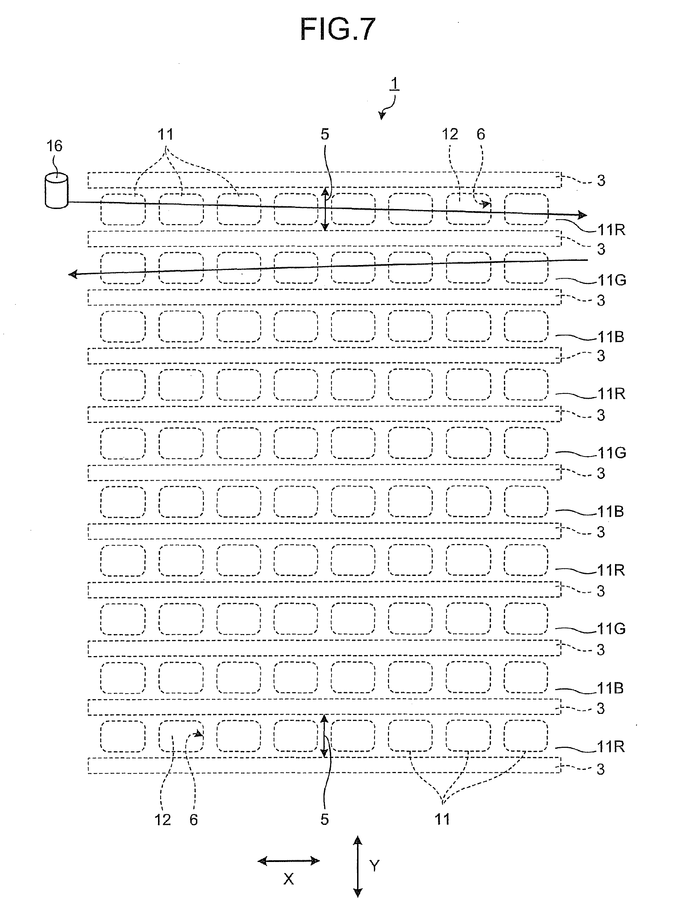

In the above-described method for manufacturing the light-emitting device 1, when the organic layer (hole injection layer 14 and light-emitting layer 15) is formed by the nozzle printing method, by reciprocating the nozzle 16, the organic layer is deposited and formed. As described above, in the conventional nozzle printing method, the nozzle 16 is not reciprocated for each line, so that there are an organic layer formed during the out-bound of the nozzle 16 and an organic layer formed during the in-bound of the nozzle 16. Then, there is a problem in that a line in which the organic layer is formed during the out-bound of the nozzle 16 and a line in which the organic layer is formed during the in-bound of the nozzle 16 are different from each other in the brightness of the manufactured organic EL element 11.
This problem is supposed to occur because even if the device is set so that the nozzle 16 is moved through the center of the concave portion 5 in a plan view, the track of the nozzle 16 during the out-bound and the in-bound may be slightly different from each other and the property of a film formed during the out-bound and the property of a film formed during the in-bound are different from each other. As illustrated in FIG. 7, for example, even when the nozzle 16 is set to be moved in the line direction X (crosswise direction) relative to the supporting substrate 2, in the out-bound in which the nozzle 16 is moved rightward, the nozzle 16 may follow a track slightly inclining downwards to the lower right from the crosswise direction, and in the in-bound in which the nozzle 16 is moved leftward, the nozzle 16 may follow a track slightly inclining downwards to the lower left from the crosswise direction. In this case, in FIG. 7, when the track of the out-bound is translated in the other direction of the column direction Y by a distance of one line and is superimposed on the track of the in-bound, the track of the out-bound does not agree with the track of the in-bound. Therefore, it is assumed that in the out-bound and the in-bound, films having properties slightly different from each other are formed.
On the contrary, in the present embodiment, the nozzle 16 is reciprocated for each line, so that even if the tracks of the out-bound and the in-bound are different from each other, as the integrated track of the track of the out-bound and the track of the in-bound, the same track is formed in every line and as a result thereof, a film having the same properties can be formed in every line. When a film in one line is compared with a film in another line, an organic EL element 11 having small light emission unevenness can be manufactured.

Although in the above description, the hole injection layer 14 that is provided commonly to all the organic EL elements 11 is formed for one line, in another embodiment, the hole injection layer 14 may be deposited and formed with an interval of two lines like the light-emitting layer 15, and may be formed in three separate times.

Although in the above description, the method for forming the organic layer of the organic EL element 11 by the nozzle printing method is described, the present invention can be applied to not only the forming method of the organic layer of the organic EL element 11, but also the forming method of a thin film for forming a prescribed thin film. That is, the present invention can be applied to a forming method of a thin film for forming a thin film in a body to be coated comprising a supporting substrate 2 and a plurality of partitions 3 provided on the supporting substrate 2 at prescribed intervals in the column direction and extending in the line direction different from the column direction, the manufacturing method comprising: supplying the liquid columnar ink between the partitions 3 and moving the ink supply position in one direction or the other direction of the line direction of the partitions 3 from one end to the other end of the line direction; and solidifying the ink supplied between the partitions 3 to form a thin film. At the supplying the ink, in each space between the partitions 3, the number of times of moving the ink supply position in one direction of the line direction and the number of times of moving the ink supply position in the other direction of the line direction are made the same as each other. Such a prescribed thin film may be a color filter or the like.

### <Composition of organic EL element>

As described above, the organic EL element 11 can take various layer compositions. However, hereinafter, the layer structure of the organic EL element 11, the composition of each layer, and the forming method of each layer are described further in detail.

As described above, the organic EL element 11 comprises a pair of electrodes (12, 13) and one or more organic layers provided between the pair of electrodes, and has as one or more organic layers, at least one light-emitting layer 15. The organic EL element 11 may comprise a layer comprising an inorganic substance and an organic substance, an inorganic layer, and the like. The organic substance comprised in the organic layer may be a low molecular compound, a macromolecular compound, or a mixture of a low molecular compound and a macromolecular compound. The organic layer comprises preferably a macromolecular compound and comprises preferably a macromolecular compound having a number average molecular weight in terms of polystyrene of 10³ to 10⁸.
When the organic layer is formed by an applying method, generally, a macromolecular compound has advantageous solubility in a solvent in comparison with a low molecular compound, so that a macromolecular compound having advantageous solubility in a solvent is preferably used.

The layer provided between the cathode and the light-emitting layer may be an electron injection layer, an electron transport layer, or a hole block layer. When, between the cathode and the light-emitting layer, both of the electron injection layer and the electron transport layer are provided, a layer nearer to the cathode is called an "electron injection layer" and a layer nearer to the light-emitting layer is called an "electron transport layer".
The layer provided between the anode and the light-emitting layer may be a hole injection layer, a hole transport layer, or an electron block layer. When both of the hole injection layer and the hole transport layer are provided, a layer nearer to the anode is called a "hole injection layer" and a layer nearer to the light-emitting layer is called a "hole transport layer".
These layers provided between the cathode and the light-emitting layer 15 and these layers provided between the anode and the light-emitting layer 15 can be provided as a common layer commonly to all the organic EL elements 11. Among these organic layers, an organic layer capable of being formed by an applying method is preferably formed by the method for forming the hole injection layer 14 and the light-emitting layer 15 above-described in the embodiment of the present invention.

Examples of the element composition of the organic EL element are illustrated as follows:
a) anode / light-emitting layer / cathode;
b) anode / hole injection layer / light-emitting layer / cathode;
c) anode / hole injection layer / light-emitting layer /electron injection layer / cathode;
d) anode / hole injection layer / light-emitting layer /electron transport layer / cathode;
e) anode / hole injection layer / light-emitting layer /electron transport layer / electron injection layer /cathode;
f) anode / hole transport layer / light-emitting layer /cathode;
g) anode / hole transport layer / light-emitting layer /electron injection layer / cathode;
h) anode / hole transport layer / light-emitting layer /electron transport layer / cathode;
i) anode / hole transport layer / light-emitting layer /electron transport layer / electron injection layer /cathode;
j) anode / hole injection layer / hole transport layer /light-emitting layer / cathode;
k) anode / hole injection layer / hole transport layer /light-emitting layer / electron injection layer / cathode;
l) anode / hole injection layer / hole transport layer /light-emitting layer / electron transport layer / cathode;
m) anode / hole injection layer / hole transport layer /light-emitting layer / electron transport layer / electron injection layer / cathode;
n) anode / light-emitting layer / electron injection layer / cathode;
o) anode / light-emitting layer / electron transport layer / cathode; and
p) anode / light-emitting layer / electron transport layer / electron injection layer / cathode.
The symbol "/" indicates that the layers interposing the symbol "/" are layered adjacent to each other. The same applies to the description below.

Furthermore, the organic EL element 11 may have two or more light-emitting layers 15, or may have two or more light-emitting layers 15 and may constitute a so-called multiphoton-type organic EL element in which a charge generating layer for generating an electric charge is interposed between the light-emitting layers 15 adjacent to each other.

The organic EL element 11 may be further covered by a sealing member such as a sealing film and a sealing plate for sealing.

In the organic EL element 11 of the present embodiment, for enhancing adhesion with the electrode and improving electric charge injecting property from the electrode, an insulation layer having a film thickness of 2 nm or less may be further provided at a position adjacent to the electrode. For enhancing adhesion or preventing mixing at the interface, a thin buffer layer may be inserted between the above-described layers.

The order of stacking layers, the number of layers, and the thickness of each layer can be set as appropriate, taking into consideration light-emitting efficiency and element life. In the organic EL element 11, among the anode and the cathode, the anode may be arranged at a position nearer to the supporting substrate 2 and the cathode may be arranged at a position distant from the supporting substrate 2. On the contrary, the cathode may be arranged at a position nearer to the supporting substrate 2 and the anode may be arranged at a position distant from the supporting substrate 2. For example, in the above compositions a) to p), each layer may be layered on the supporting substrate 2 in the order from the leftmost layer or on the contrary, in the order from the rightmost layer.

Next, the material and the forming method of each layer constituting the organic EL element 11 are more specifically described.

### <Anode>

In the case of an organic EL element 11 having a composition in which light emitted from the light-emitting layer 15 is emitted through the anode, an electrode exhibiting optical transparency is used for the anode. As the electrode exhibiting optical transparency, a thin film of a metal oxide, a metal sulfide, or a metal having high electric conductivity can be used and a material having high light transmittance is preferably used. Specifically, there is used a thin film composed of indium oxide, zinc oxide, tin oxide, indium tin oxide (ITO), indium zinc oxide (IZO), gold, platinum, silver, copper, or the like and among them, a thin film composed of ITO, IZO, or tin oxide is preferably used. The forming method of the anode may be a vacuum evaporation method, a sputtering method, an ion plating method, and a plating method. As the anode, an organic transparent conductive film of a polyamine or derivatives thereof, a polythiophene or derivatives thereof, or the like may be used.

In the case of an organic EL element 11 having a composition in which light emitted from the light-emitting layer 15 is emitted through the cathode, a material reflecting light may be used for the anode and preferred examples of such a material may be a metal, a metal oxide, or a metal sulfide, having a work function of 3.0 eV or more.

The film thickness of the anode can be selected as appropriate, taking into consideration transparency of light and electric resistance. The thickness is, for example 10 nm to 10 µm, preferably 20 nm to 1 µm, and further preferably 50 nm to 500 nm.

### <Hole injection layer>

Examples of the hole injection material constituting the hole injection layer 14 include: an oxide such as vanadium oxide, molybdenum oxide, ruthenium oxide, and aluminum oxide; a phenylamine compound; a star burst-type amine compound; a phthalocyanine compound; an amorphous carbon; a polyaniline; and a polythiophene derivative.

Examples of the film-forming method of the hole injection layer include film forming from a solution comprising a hole injection material. The solvent of the solution used for film forming from the solution is not particularly limited so long as the solvent is a solvent capable of dissolving the hole injection material.
Examples of the solvent include: chlorinated solvents such as chloroform, methylene chloride, and dichloroethane; ether solvents such as tetrahydrofuran; aromatic hydrocarbon solvents such as toluene and xylene; ketone solvents such as acetone and methyl ethyl ketone; ester solvents such as ethyl acetate, butyl acetate, and ethylcellosolve acetate; and water.

The film-forming method from the solution may be applying methods such as a spin coating method, a casting method, a micro gravure coating method, a gravure coating method, a bar coating method, a roll coating method, a wire bar coating method, a dip coating method, a spray coating method, a screen printing method, a flexo printing method, an off-set printing method, an inkjet printing method, or a nozzle printing method. The hole injection layer 14 is preferably formed by the above-described nozzle printing method according to the present invention.

The film thickness of the hole injection layer 14 is set as appropriate, taking into consideration electric characteristics and easiness of film forming. The film thickness of the hole injection layer 14 is, for example, 1 nm to 1 µm, preferably 2 nm to 500 nm, and further preferably 5 nm to 200 nm.

### <Hole transport layer>

Examples of the hole transport material constituting the hole transport layer include polyvinyl carbazole or derivatives thereof, polysilane or derivatives thereof, a polysiloxane derivative having an aromatic amine in side chains or the main chain, a pyrazoline derivative, an arylamine derivative, a stilbene derivative, a triphenyldiamine derivative, polyaniline or derivatives thereof, polythiophene or derivatives thereof, a polyarylamine or derivatives thereof, polypyrrole or derivatives thereof, poly(p-phenylenevinylene) or derivatives thereof, and poly(2,5-thienylenevinylene) or derivatives thereof.

Among these hole transport materials, preferred are macromolecular hole transport materials such as polyvinyl carbazole or derivatives thereof, polysilane or derivatives thereof, a polysiloxane derivative having an aromatic amine compound group in side chains or the main chain, polyaniline or derivatives thereof, polythiophene or derivatives thereof, polyarylamine or derivatives thereof, poly(p-phenylenevinylene) or derivatives thereof, and poly(2,5-thienylenevinylene) or derivatives thereof, and further preferred are polyvinyl carbazole or derivatives thereof, polysilane or derivatives thereof, and a polysiloxane derivative having aromatic amine in side chains or the main chain. A low molecular hole transport material is preferably used by being dispersed in a macromolecular binder.

The film-forming method of the hole transport layer is not particularly limited. The film-forming method using a low molecular hole transport material may be film forming from a mixture comprising a macromolecular binder and a hole transport material, and the film-forming method using a macromolecular hole transport material may be film forming from a solution containing a hole transport material.

The solvent of the solution used for film forming from the solution is not particularly limited so long as the solvent is a solvent capable of dissolving the hole transport material. Solvents exemplified as the solvent of the solution used for forming the hole injection layer 14 from the solution can be used as the hole transport material.

The film-forming method from the solution may be the same applying method as the above-described film-forming method of the hole injection layer 14. The hole transport layer is preferably formed by the above-described nozzle printing method of the present invention.

As the macromolecular binder to be mixed, a binder that does not extremely inhibit the electric charge transport is preferred and a binder that absorbs weakly a visible light is preferably used. Examples of such a binder include polycarbonate, polyacrylate, polymethyl acrylate, polymethyl methacrylate, polystyrene, polyvinyl chloride, and polysiloxane.

The film thickness of the hole transport layer is set as appropriate, taking into consideration electric characteristics and easiness of film forming. The film thickness of the hole transport layer is, for example, 1 nm to 1 µm, preferably 2 nm to 500 nm, and further preferably 5 nm to 200 nm.

### <Light-emitting layer>

The light-emitting layer is usually formed mainly from an organic substance emitting fluorescence and/or phosphorescence, or this organic substance and a dopant assisting the organic substance. The dopant is blended, for example, for enhancing light-emitting efficiency or changing the light-emitting wavelength. The organic substance may be a low molecular compound or a macromolecular compound. The light-emitting layer comprises preferably a macromolecular compound having a number average molecular in terms of polystyrene of 10³ to 10⁸. Examples of the light-emitting material constituting the light-emitting layer include dye materials, metal complex materials, macromolecular materials, and dopant materials below.

### (Dye materials)

Examples of the dye materials include cyclopentamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal complex materials)

Examples of the metal complex materials include metal complexes having as a central metal, a rare metal such as Tb, Eu, and Dy, or Al, Zn, Be, Ir, or Pt and having as a ligand, an oxadiazole, thiadiazole, phenylpyridine, phenylbenzimidazole, or quinoline structure. Examples of metal complexes include metal complexes having light-emitting from a triplet excited state such as indium complexes and platinum complexes, aluminum-quinolinole complexes, benzoquinolinol-beryllium complexes, benzoxazolyl-zinc complexes, benzothiazole-zinc complexes, azomethyl-zinc complexes, porphyrin-zinc complexes, and phenanthroline-europium complexes.

### (Macromolecular materials)

Examples of the macromolecular materials include materials prepared by polymerizing poly-p-phenylenevinylene derivatives, polythiophene derivatives, poly-p-phenylene derivatives, polysilane derivatives, polyacetylene derivatives, polyfluorene derivatives, polyvinylcarbazole derivatives, the above dye materials or metal complex light-emitting materials.

Among the above light-emitting materials, examples of the material emitting blue light include distyrylarylene derivatives and polymers of thereof, oxadiazole derivatives and polymers thereof, polyvinylcarbazole derivatives, poly-p-phenylene derivatives, and polyfluorene derivatives. Among them, preferred are macromolecular materials such as polyvinylcarbazole derivatives, poly-p-phenylene derivatives, and polyfluorene derivatives.

Examples of the materials emitting green light include quinacridone derivatives and polymers thereof, coumarin derivatives and polymers thereof, poly-p-phenylenevinylene derivatives, and polyfluorene derivatives. Among them, preferred are macromolecular materials such as poly-p-phenylenevinylene derivatives and polyfluorene derivatives.

Examples of the materials emitting red light include coumarin derivatives and polymers thereof, thiophene ring compounds and polymers thereof, poly-p-phenylenevinylene derivatives, polythiophene derivatives, and polyfluorene derivatives. Among them, preferred are macromolecular materials such as poly-p-phenylenevinylene derivatives, polythiophene derivatives, and polyfluorene derivatives.

### (Dopant materials)

Examples of the dopant materials include perylene derivatives, coumarin derivatives, rubrene derivatives, quinacridone derivatives, squarylium derivatives, porphyrin derivatives, styryl dyes, tetracene derivatives, pyrazolone derivatives, decacyclene, and phenoxazone. The thickness of such a light-emitting layer is usually 2 nm to 200 nm.

Examples of the film-forming method of the light-emitting material include a printing method, an inkjet printing method, and a nozzle printing method. For example, as described above, it is possible to paint different colors by the nozzle printing method of the present invention.

### <Electron transport layer>

As the electron transport material constituting the electron transport layer, a publicly-known electron transport material can be used. Examples of the electron transport material include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, a metal complex of 8-hydroxyquinoline or derivatives thereof, polyquinoline or derivatives thereof, polyquinoxaline or derivatives thereof, and polyfluorene or derivatives thereof.

Among them, as the electron transport material, preferred are oxadiazole derivatives, benzoquinone or derivatives thereof, anthraquinone or derivatives thereof, a metal complex of 8-hydroxyquinoline or derivatives thereof, polyquinoline or derivatives thereof, polyquinoxaline or derivatives thereof, and polyfluorene or derivatives thereof, and further preferred are 2-(4-biphenylyl)-5-(4-tert-butylphenyl)-1,3,4-oxadiazole, benzoquinone, anthraquinone, tris(8-quinolinol) aluminum, and polyquinoline.

The film-forming method of the electron transport layer is not particularly limited. The film-forming method using a low molecular electron transport material may be a vacuum evaporation method from powder and film forming from a solution or a molten state, and The film-forming method using a macromolecular electron transport material may be film forming from a solution or a molten state. In the case of film forming from a solution or a molten state, a macromolecular binder may be used in combination. The film-forming method from a solution may be the same applying method as the above-described film-forming method of the hole injection layer 14.

The film thickness of the electron transport layer is set as appropriate, taking into consideration electric characteristics and easiness of film forming. The film thickness of the electron transport layer is, for example, 1 nm to 1 µm, preferably 2 nm to 500 nm, and further preferably 5 nm to 200 nm.

### <Electron injection layer>

As the material constituting the electron injection layer 14, an optimal material is selected as appropriate according to the type of the light-emitting layer 15. Examples of the material constituting the electron injection layer include an alkali metal, an alkaline earth metal, an alloy containing one or more types of an alkali metal and an alkaline earth metal, an oxide, a halide, or a carbonate of an alkali metal or an alkaline earth metal, and a mixture of these substances. Examples of the alkali metal and the oxide, the halide, and the carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline earth metal and the oxide, the halide, and the carbonate of the alkaline earth metal include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be constituted with a layered body prepared by stacking two or more layers and examples thereof include a layered body of a LiF film and a Ca film. The electron injection layer is formed by an evaporation method, a sputtering method, a printing method, or the like. The film thickness of the electron injection layer is preferably around 1 nm to 1 µm.

### <Cathode>

The material for the cathode is preferably a material having a small work function and a high electric conductivity and capable of easily injecting electrons into the light-emitting layer. An organic EL element configured to retrieve light from the side of the anode reflects light emitted from the light-emitting layer on the cathode toward the anode, so that the material for the cathode is preferably a material having a high visible light reflectivity.
Examples of the materials for the cathode may include alkali metals, alkaline earth metals, transition metals, and metals of Group 13 in the Periodic Table. Specific examples of the materials for the cathode include: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more types of these metals; alloys of one or more types of these metals with one or more typ(s of gold, silver, platinum, copper, manganese, titanium, cobalt, nickel, tungsten, and tin; and graphite or graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. As the cathode, a transparent conductive electrode comprising a conductive metal oxide and a conductive organic substance can be used. Specifically, the conductive metal oxide may be indium oxide, zinc oxide, tin oxide, ITO, and IZO. Specifically, the conductive organic substances may be polyaniline or derivatives thereof and polythiophene or derivatives thereof. The cathode may be constituted by a layered body prepared by stacking two or more layers. The electron injection layer may be used as the cathode.

The film thickness of the cathode is set as appropriate, taking into consideration electric conductivity and durability. The film thickness of the cathode is, for example, 10 nm to 10 µm, preferably 20 nm to 1 µm, further preferably 50 nm to 500 nm.

Examples of the production method of the cathode include a vacuum evaporation method, a sputtering method, and a laminate method for thermocompression-bonding a metal thin film.

### <Insulation layer>

Examples of the materials for the insulation layer include a metal fluoride, a metal oxide, and an organic insulating material. The organic EL element provided with an insulation layer having a film thickness of 2 nm or less may be an organic EL element provided with an insulation layer having a film thickness of 2 nm or less at a position adjacent to the cathode and an organic EL element provided with an insulation layer having a film thickness of 2 nm or less at a position adjacent to the anode.

### EXPLANATIONS OF LETTERS OR NUMERALS

- 1: Light-emitting device

- 2: Supporting substrate
- 3: Partition
- 4: Insulation film
- 5: Concave portion
- 6: Opening
- 11: Organic EL element
- 12: One electrode
- 13: the other electrode
- 14: Hole injection layer
- 15: Light-emitting layer
- 16: Nozzle

## Claims

1. A method for manufacturing a light-emitting device that comprises a supporting substrate, a plurality of partitions arranged on the supporting substrate at prescribed intervals in a column direction and extending in a line direction different from the column direction, and a plurality of organic electroluminescent elements provided in a plurality of concave portions each of which is a gap between the partitions adjacent to each other, each of the organic electroluminescent elements comprising a pair of electrodes and one or more organic layers provided between the pair of electrodes,
the method comprising the steps of:
forming one electrode among the pair of electrodes;
supplying an ink comprising a material to be the organic layer in a liquid columnar pattern to the concave portions and moving a supply position of the ink in one direction or the other direction of the line direction of the partitions from one end to the other end of the line direction;
solidifying the ink supplied to the concave portions to form the organic layer; and
forming the other electrode among the pair of electrodes, wherein
at the step of supplying the ink, in each of the concave portions, the number of times of moving the ink supply position in one direction of the line direction and the number of times of moving the ink supply position in the other direction of the line direction are made same as each other.

2. The method for manufacturing the light-emitting device according to claim 1, wherein at the step of supplying the ink, in each of the concave portions, the ink supply position is moved in one direction of the line direction and then moved further in the other direction in the same concave portion to reciprocate the ink supply positions for each concave portion to supply the ink.

3. The method for manufacturing the light-emitting device according to claim 1, wherein the step of supplying the ink comprises:
a first step for moving the ink supply position so that the moving directions of the ink supply position in the concave portions adjacent to each other becomes different from each other to supply the ink to all the concave portions; and
a second step for moving the ink supply position so that in each concave portion to which the ink has been already supplied in the first step, the moving direction of the ink supply position becomes different from the moving direction in the first step to further supply the ink to all the concave portions.

4. The method for manufacturing the light-emitting device according to claim 1, wherein the step of supplying the ink comprises:
a first step for moving the ink supply position so that the moving directions of the ink supply position in the concave portions adjacent to each other become different from each other to supply the ink to all the concave portions; and
a second step for moving the ink supply position so as to follow the moving direction of the ink supply position in the reverse direction from the moving direction in the first step to the concave portion to which the ink has been already supplied in the first step to further supply the ink to all the concave portions.

5. The method for manufacturing the light-emitting device according to claim 1, wherein the step of supplying the ink is a step for supplying two or more types of inks to the concave portions without overlapping the types of inks in each concave portion, and the step of supplying the ink comprises:
a first step for moving the ink supply position in one direction of the line direction and then moving further in the other direction in the same concave portion to reciprocate the ink supply positions for each concave portion;
a second step for repeating a step comprising moving the ink supply position from the concave portion to which an ink has been already supplied so as to skip a given number of lines of concave portions, where the given number is obtained by subtracting one from the number of types of inks, moving the ink supply position in one direction of the line direction, and then moving further in the other direction of the line direction in the same concave portion to reciprocate the ink supply positions for each concave portion; and
a third step for repeating a step comprising moving the ink supply position in one direction of the line direction in a concave portion different from the concave portion to which the ink has been already supplied with using an ink of a type different from the ink that has been already supplied, moving further in the other direction in the same concave portion to reciprocate the ink supply positions for each concave portion, moving the ink supply position from the concave portion to which the ink has been already supplied so as to skip the give number of lines of concave portions, where the given number is obtained by subtracting one from the number of types of inks, moving the ink supply position in one direction of the line direction, and then moving further in the other direction in the same concave portion to reciprocate the ink supply positions for each concave portion.

6. The method for manufacturing the light-emitting device according to claim 1, wherein the step of supplying the ink is a step for supplying two or more types of inks to the concave portions without the types of inks in each concave portion, and the step of supplying the ink comprises:
a first step for repeating a step comprising moving the ink supply position in one direction of the line direction, moving the ink supply position from the concave portion to which an ink has been already supplied so as to skip a given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
a second step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks; and
a third step for repeating a step comprising moving the ink supply position in the other direction of the line direction to supply the ink of the same type as the ink that has been already supplied to the concave portion to which the ink has been already supplied so that the moving direction of the ink supply position becomes different from the moving direction of the ink supply position of the ink that has been already supplied, moving the ink supply position from the concave portion to which the ink has been already supplied so as to skip the given number of lines of concave portions, where the given number is obtained by subtracting one from the number of types of inks, moving the ink supply position in one direction of the line direction, and moving the ink supply position from the concave portion to which the ink has been already supplied so as to skip the given number of lines of concave portions, where the given number is obtained by subtracting one from the number of types of inks.

7. The method for manufacturing the light-emitting device according to claim 1, wherein the step of supplying the ink is a step for supplying two or more types of inks to the concave portions without overlapping the types of inks in each concave portion, and the step of supplying the ink comprises:
a first step for repeating a step comprising moving the ink supply position in one direction of the line direction, moving the ink supply position from the concave portion to which an ink has been already supplied so as to skip a given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
a second step for further supplying the ink of the same type as the ink that has been already supplied to the concave portion to which the ink has been already supplied, by reciprocating the ink supply positions so as to follow the moving direction of the ink supply position in the reverse direction from the moving direction in the first step; and
a third step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks, and thereafter repeating a step for further supplying the ink of the same type as the ink that has been already supplied to the concave portion to which the ink has been already supplied, by reciprocating the ink supply positions so as to follow the moving direction of the ink supply position in the reverse direction from the moving direction of the ink supply position of the ink that has been already supplied.

8. A method for manufacturing a thin film for forming a thin film in a body to be coated comprising a supporting substrate and a plurality of partitions provided on the supporting substrate at subscribed intervals in a column direction and extending in a line direction different from the column direction, the method comprising the steps of:
supplying a liquid columnar ink to a plurality of concave portions each of which is a gap between the partitions and moving an ink supply position in one direction or the other direction of the line direction of the partitions from one end to the other end of the line direction; and
solidifying the ink supplied to the concave portions to form a thin film, wherein
at the step of supplying the ink, in each of the concave portions, the number of times of moving the ink supply position in one direction of the line direction and the number of times of moving the ink supply position in the other direction of the line direction are made same as each other.

9. The method for manufacturing a thin film according to claim 8, wherein at the step of supplying the ink, in each of the concave portions, the ink supply position is moved in one direction of the line direction and then moved further in the other direction in the same concave portion to reciprocate the ink supply positions for each concave portion to supply the ink.

10. The method for manufacturing a thin film according to claim 8, wherein the step of supplying the ink comprises:
a first step for moving the ink supply position so that the moving directions of the ink supply position in the concave portions adjacent to each other become different from each other to supply the ink to all the concave portions; and
a second step for moving the ink supply position so that the moving direction of the ink supply position becomes different from the moving direction in the first step in each concave portion to which the ink has been already supplied in the first step to further supply the ink to all the concave portions.

11. The method for manufacturing a thin film according to claim 8, wherein the step of supplying the ink comprises:
a first step for moving the ink supply position so that the moving directions of the ink supply position in the concave portions adjacent to each other become different from each other to supply the ink to all the concave portions; and
a second step for moving the ink supply position so as to follow the moving direction of the ink supply position in the reverse direction from the moving direction in the first step in the concave portion to which the ink has been already supplied in the first step to further supply the ink to all concave portions.

12. The method for manufacturing a thin film according to claim 8, wherein the step of supplying the ink is a step of supplying two or more types of inks to the concave portions without overlapping the types of inks in each concave portion, and the step of supplying the ink comprises:
a first step for moving the ink supply position in one direction of the line direction and then moving further in the other direction in the same concave portion to reciprocate the ink supply positions for each of the concave portions;
a second step for repeating a step comprising moving the ink supply position from the concave portion to which an ink has been already supplied so as to skip a given number of lines of concave portions, where the given number is obtained by subtracting one from number of types of inks, moving the ink supply position in one direction of the line direction, and then moving further in the other direction in the same concave portion to reciprocate the ink supply positions for each concave portion; and
a third step for repeating a step comprising moving the ink supply position in one direction of the line direction to a concave portion different from the concave portion to which the ink has been already supplied with using an ink of a type different from the ink that has been already supplied, moving further in the other direction in the same concave portion to reciprocate the ink supply positions for each concave portion, and then moving the ink supply position from the concave portion to which the ink has been already supplied so as to skip the given number of lines of concave portions, where the given number is obtained by subtracting one from the number of types of inks, moving the ink supply position in one direction of the line direction, and then moving further in the other direction in the same concave portion to reciprocate the ink supply positions for each concave portion.

13. The method for manufacturing a thin film according to claim 8, wherein the step of supplying the ink is a step of supplying two or more types of inks to the concave portions without overlapping the types of inks in each concave portion, and the step of supplying the ink comprises:
a first step for repeating a step comprising moving the ink supply position in one direction of the line direction, moving the ink supply position from the concave portion to which the ink has been already supplied so as to skip a given number of lines of concave portions, where the given number is obtained by subtracting one from number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
a second step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks; and
a third step for repeating a step comprising moving the ink supply position in the other direction of the line direction to supply the ink of the same type as the ink that has been already supplied to the concave portion to which the ink has been already supplied so that the moving direction of the ink supply position becomes different from the moving direction of the ink supply position of the ink that has been already supplied, moving the ink supply position from the concave portion to which the ink has been already supplied so as to skip the number of lines of concave portions, where the given number is obtained by subtracting one from the number of types of inks, moving the ink supply position in one direction of the line direction, and moving the ink supply position from the concave portion to which the ink has been already supplied so as to skip the given number of lines of concave portions, where the given number is obtained by subtracting one from the number of types of inks.

14. The method for manufacturing a thin film according to claim 8, wherein the step of supplying the ink is a step of supplying two or more types of inks to the concave portions without overlapping the types of inks in each concave portion, and the step of supplying the ink comprises:
a first step for repeating a step comprising moving the ink supply position in one direction of the line direction, moving the ink supply position from the concave portion to which an ink has been already supplied so as to skip a given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks;
a second step for further supplying the ink of the same type as the ink that has been already supplied to the concave portion to which the ink has been already supplied, by reciprocating the ink supply positions so as to follow the moving direction of the ink supply position in the reverse direction from the moving direction in the first step; and
a third step for repeating a step comprising moving the ink supply position in one direction of the line direction to a concave portion different from the concave portion to which the ink has been already supplied with using an ink of a type different from the ink that has been already supplied, moving the ink supply position from the concave portion to which the ink has been already supplied so as to skip the given number of lines of concave portions, where the given number is obtained by subtracting one from the number of types of inks, moving the ink supply position in the other direction of the line direction, and moving the ink supply position from the concave portion to which the ink has been already supplied so as to skip the given number of lines of concave portions, where the given number is obtained by subtracting one from the number of types of inks, and thereafter repeating a step for further supplying the ink of the same type as the ink that has been already supplied to the concave portion to which the ink has been already supplied, by reciprocating the ink supply positions so as to follow the moving direction of the ink supply position in the reverse direction from the moving direction of the ink supply position of the ink that has been already supplied.
